(19) Europäisches Patentamt
European Patent Office
Office européen des brevets

(11) Veröffentlichungsnummer: **0 151 553**
A2

(12) **EUROPÄISCHE PATENTANMELDUNG**

(21) Anmeldenummer: 85810027.4

(22) Anmeldetag: 28.01.85

(51) Int. Cl.⁴: C 08 L 63/00
C 08 L 81/06, C 08 G 59/62
C 08 G 59/50

(30) Priorität: 03.02.84 US 576698

(43) Veröffentlichungstag der Anmeldung: 14.08.85 Patentblatt 85/33

(84) Benannte Vertragsstaaten: CH DE FR GB LI NL

(71) Anmelder: CIBA-GEIGY AG
Postfach
CH-4002 Basel(CH)

(72) Erfinder: Helfand, David
3792 Wildwood Street
Yorktown Heights New York 10598(US)

(72) Erfinder: Cheetham, Kevin J.
RD No. 6 Old Road
Brewster New York 10509(US)

(54) **Epoxiharz/Polysulfon-Formmassen für gehärtete Produkte mit ausgezeichneter Riss- und Feuchtigkeitsbeständigkeit.**

(57) Formmassen mit einem Gehalt an (a) einem Gemisch eines festen Epoxiharzes mit einem 6-14 gew.-%igem Anteil eines innig damit vermischten Polysulfons, (b) einem Novolak-Härter und (c) einem Beschleuniger, führen zur Bildung gehärteter Harzprodukte mit ausgezeichneter Widerstandsfähigkeit gegen Rissbildung, Feuchtigkeit und thermischen Schock. Gehärtete Harze dieser Art finden als Einbettungsmaterialien für elektrische und Halbleiterbauelemente Verwendung.

EP 0 151 553 A2

Croydon Printing Company Ltd.

# Epoxiharz/Polysulfon-Formmassen für gehärtete Produkte mit ausgezeichneter Riss- und Feuchtigkeitsbeständigkeit

Die vorliegende Erfindung erstreckt sich auf Formmassen mit einem Gehalt an einem festen Epoxiharz mit einem 6-14 gew.-%igem Anteil eines innig damit vermischten Polysulfons, einem Novolak-Härter und einem Beschleuniger, die zur Bildung gehärteter Harze mit ausgezeichneter Widerstandsfähigkeit gegen Rissbildung, Feuchtigkeit und thermischen Schock führen.

Seit Entdeckung der Polymeren wurden immer wieder Versuche unternommen, die Eigenschaften von Polymerprodukten in der Weise zu verbessern, dass man verschiedene Polymertypen miteinander vermischte, um aus den spezifischen Eigenschaften jeder Mischungskomponente Vorteile zu ziehen. Man findet in den Publikationen des Standes der Technik Hinweise auf solche Versuche in stattlicher Anzahl. Diese schliessen sowohl u.a. Polysulfone als auch Epoxiharze ein.

Wie aus US-A-4 332 732 ersichtlich ist, wurden solche Gemische insbesondere auf dem Gebiet der Klebstoffe verwendet. Aus dieser Patentschrift sind Gemische aus flüssigen Epoxiharzen und verschiedenen Thermoplasten wie z.B. Polyolefinen, Polyamiden, Polyvinylbutyral und dgl. bekannt, wobei jedoch Polysulfone in dieser Aufzählung von Thermoplasten nicht eingeschlossen sind.

Aus der US-A-3 530 087 sind weitere Epoxiharze niedrigen Molekulargewichts im Gemisch mit Polysulfonen enthaltende Klebstoffmassen bekannt. Das Epoxiharz und Polysulfon werden in geschmolzenem Zustand vermischt, wobei die Gemische 10-100, vorzugsweise 30-60 Teile Polysulfon,

bezogen auf 100 Teile Epoxiharz enthalten. In diesem Patent wird jedoch keine Lehre darüber vermittelt, dass man feste Epoxiharze verwenden, das Polysulfon darin innig verteilen oder Novolak-Härter einsetzen soll, oder dass überlegene Widerstandsfähigkeit gegen Rissbildung, Feuchtigkeit oder thermischen Schock in den gehärteten Produkten aus Klebstoffmassen nach US-A-3 530 087 erzielbar ist.

Als man Formmassen auf Epoxiharzbasis zum ersten Mal in den Fünfzigerjahren zur Einbettung von festen Bauelementen verwendete, bildeten feste bifunktionelle mit Anhydridhärtern gehärtete Bisphenol-A-Epoxiharze ihre Grundlage.

Man ersetzte dieses auch "Epoxi A" genannte System in den späten Sechzigerjahren durch ein verbessertes im allgemeinen "Epoxi B" genanntes System. Dieses basiert auf der Grundlage von multifunktionellen Epoxi/Kresol-Novolakharzen (ECN), welche mit phenolischen Novolak-Härtern ausgehärtet sind.

Gegenwärtig befinden sich verschiedene "Epoxi B"-Spritzpressmassen im Handel, welche als wirtschaftlichste Mittel für die Einbettung vieler Typen von aktiven Halbleiterbauelementen, insbesondere in der Dual-in-line-Gehäuse (DIP)-Anordnung weite Verwendung finden.

Als Ergebnis der Integrierung in grösserem Massstab haben die Dimensionen und Anzahl der Zuleitungen der Dual-in-line Gehäuse (DIP) zugenommen. Diese grösseren DIP-Gehäuse, insbesondere die 40-Leiter-Varianten haben eine stärkere Neigung zur Rissbildung als kleinere Gehäuse, wenn man sie einer thermisch induzierten Belastung aussetzt.

Verbesserungen der Fähigkeit von Einbettungsmaterialien, Unterschieden der thermischen Ausdehnungskoeffizienten im Gehäuse standzuhalten, sind unabdingbare Bestrebungen der Industrie zur Erhöhung der Gesamtausbeute und der Zuverlässigkeit.

Ein wesentlicher Unterschied zwischen Epoxidharzen auf Bisphenol A-Basis und Epoxi/Kresol-Novolaken ist in ihrer Funktionalität zu sehen. Die Bisphenol A-Epoxiharze sind sämtlich bifunktionell, wohingegen die Epoxi-Novolakharze,

wie z.B. Epoxi/Kresol-Novolak (ECN) für die Anwendung als Formmassen eine Funktionalität im Bereich von ungefähr 3-5 aufweisen.

Zahlreiche Vorteile des Epoxi B-Systems gegenüber dem Epoxi A-System liegen in erster Linie in der grösseren Funktionalität des ECN-Harzes. Während des Härtens tritt eine höhere Vernetzungsdichte ein, welche eine niedrigere Feuchtigkeitsabsorption und eine höhere Glasübergangstemperatur bewirkt.

Es gibt eine Reihe von Gründen, warum grössere mit Epoxikunststoff eingebettete DIP-Gehäuse manchmal reissen, sobald sie Temperaturschwankungen während des Einbrennens, beim Nachhärten oder gelegentlichem ungewöhnlichem Ueberhitzen ausgesetzt sind.

Erstens ist die gehärtete Matrix des Einbettungsmaterials, wiederum wegen der hohen Vernetzungsdichte, an sich spröde und verformt sich vor dem endgültigen Reissen nur geringfügig.

Zweitens baut sich aufgrund der Unterschiede in den thermischen Ausdehnungskoeffizienten zwischen Einbettungsmaterial und eingebetteten Bauteilen wie z.B. dem Chip und Zuleitungsrähmchen so lange eine Spannung auf, bis das Einbettungsmaterial reisst.

Auch die Gehäusegeometrie kann die Rissbildung beeinflussen. Wandstärke, die Verhältnisse zwischen Länge, Breite und Tiefe wie auch das Vorhandensein von scharfen Kanten im Gehäuse, welche als spannungsverstärkende Faktoren eine Rolle spielen, üben jeweils einen Einfluss aus.

Die typische Formmassenformulierung setzt sich aus verschiedenen Bestandteilen zusammen, wozu Harze, Härter, Beschleuniger, flammhemmende Mittel, Haftvermittler, eingearbeitete Formentrennmittel, Pigmente und Füllstoffe zählen.

Je nach Abwandlung dieser, oder Zugabe zu diesen Komponenten ist es möglich, die Neigung des Einbettungsmaterials zur Rissbildung bei thermischer Schockbelastung zu verringern.

Eine üblicherweise praktizierte Rezepturabänderung ist das Anreichern mit Füllstoffen von ungefähr 65 bis

ungefähr 70 Gew.-%. Diese Vergrösserung des Füllstoffanteils verringert den linearen thermischen Ausdehnungskoeffizienten des Einbettungsmaterials insoweit, als dessen Koeffizient stärker jenem der eingebetteten Bauteile gleicht, so dass die infolge der thermischen Ausdehnungsunterschiede aufgebaute Spannung verringert wird.

Andere den Füllstoff betreffende Abwandlungen bedingen Abänderung der Füllstoffsorte wie auch den Zusatz von Verstärkungsmaterialien in Form von gemahlenen oder sehr kurzen Fasern anstelle von teilchenförmigem Material zur Erzielung einer höheren, der Spannung besser standhaltenden mechanischen Festigkeit. Gewöhnlich ist jedoch eine verringerte Verformbarkeit bei solchen Modifikationen von Nachteil.

Die Harzmodifikation führte man bisher unter Verwendung von Butadien/Acrylnitrilcopolymeren mit endständigen Carboxyl- oder Amingruppen durch. Trotz verbesserter Rissbeständigkeit und höherer Zähigkeit werden andere Härtungseigenschaften wie z.B. Glasübergangstemperatur beeinträchtigt.

Die vorliegende Erfindung erstreckt sich insbesondere auf härtbare Formmassen für gehärtete Harze mit überlegener Widerstandsfähigkeit gegen Rissbildung, Feuchtigkeit und thermischen Schock, welche dadurch gekennzeichnet sind, dass sie (a) ein Gemisch, bestehend aus (1) 94-86 Gew.-% eines festen Epoxiharzes mit einem Molekulargewicht von mindestens 750, bezogen auf Gemisch (a) und (2) 6-14 Gew.-% eines Polysulfons mit einem Molekulargewicht von mindestens 10 000, bezogen auf Gemisch (a), wobei das Polysulfon (2) im Epoxiharz (1) zwar unlöslich ist, aber darin in innig verteilter Form vorliegt, und wobei vorstehendes Gemisch (a) in der Weise gebildet wird, dass man das Epoxiharz (1) und das Polysulfon (2) zusammen in einem niedrig siedenden Lösungsmittel zur Erzielung einer homogenen Lösung auflöst und danach das Lösungsmittel zur Gewinnung des Gemisches (a) entfernt, (b) einen Novolak-Härter und (c) eine wirksame Menge eines Beschleunigers enthalten, wobei die Menge

an Novolak-Härter (b) im wesentlichen so bemessen ist, dass 0,85-1 phenolische Hydroxylgruppe pro Epoxidgruppe im Epoxiharz (1) entfallen.

Die erfindungsgemäss als vorteilhaft befundenen Epoxiharze sind Feststoffe mit einem Molekulargewicht von mindestens 750 und einem mittleren Gehalt von mehr als einer 1,2-Epoxigruppe pro Molekül. Diese Stoffe sind aus der Wechselwirkung von Verbindungen mit einem Gehalt an zwei oder mehr phenolischen Hydroxylgruppen pro Molekül mit Epichlorhydrin oder Glyzerindichlorhydrin unter alkalischen Bedingungen oder alternativ in Anwesenheit eines sauren Katalysators mit nachfolgender Alkalibehandlung hervorgegangene Polyglycidylether. Diese Verbindungen können sich von Phenolen wie z.B. Resorcin, Brenzkatechin, Hydrochinon, 1,4-Dihydroxynaphthalin, 1,5-Dihydroxynaphthalin, Bis-(4-hydroxyphenyl)-methan, Bis-(4-hydroxyphenyl)-methylphenylmethan, Bis-(4-hydroxyphenyl)-tolylmethan, 4,4'-Dihydroxydiphenyl, Bis-(4-hydroxyphenyl)-sulfon, 1,1,2,2-Tetrakis-(4-hydroxyphenyl)-ethan und insbesondere 2,2-Bis-(4-hydroxyphenyl)-propan oder Phenol/Formaldehyd- und Kresol/Formaldehyd-Novolakharze ableiten.

Ganz besonders bevorzugt unter den vorteilhaften erfindungsgemässen Epoxiharzen sind die Epoxi/Kresol-Novolak-Harze.

Beispiele für erfindungsgemäss besonders vorteilhaft befundene Epoxiharze sind die festen Epoxi-o-Kresol/Formaldehyd-Novolak-Harze 1 bis 3 mit einem Schmelzpunkt von 73,80 bzw. 99°C, einem Molekulargewicht von 1080, 1170 bzw. 1270 und einem Epoxiwert von 0,445, 0,435 bzw. 0,425 Aequivalenten/100 Gramm; das feste Bisphenol A-Epoxiharz 4 mit einem Molekulargewicht von 2000 und einem Epoxiwert von ungefähr 0,20 Aequivalenten/100 Gramm und der feste Epoxi/Phenol/Formaldehyd-Novolak 5 mit einem Molekulargewicht von 4000-5600. Besonders bevorzugt sind die Harze 1 und 2.

Die erfindungsgemäss als vorteilhaft befundenen Polysulfonharze weisen die wiederkehrende Einheit der Formel

$$-A-SO_2-$$

auf, worin A eine zweiwertige, gegebenenfalls durch Ethersauerstoffatome und/oder zweiwertige aliphatische Gruppen unterbrochene aromatische Gruppe bedeutet.

Vorzugsweise hat das Polysulfon eine Wärmeformbeständigkeitstemperatur von wenigstens 150°C, gemessen nach der ASTM-Spezifikation D648 und ein durchschnittliches Molekulargewicht von mindestens 10 000.

Die einzusetzenden Polysulfone können in bekannter Weise z.B. dadurch erhalten werden, dass man entweder (a) ein Sulfonylhalogenid der Formel $HA_1SO_2X$ oder (b) ein Gemisch eines Disulfonylhalogenids der Formel $XSO_2A_1SO_2X$ mit einer sulfonylhalogenidfreien Verbindung der Formel $HA_2H$, worin $A_1$ und $A_2$ gleich oder verschieden sind und jeweils eine zweiwertige gegebenenfalls durch Ethersauerstoffatome und/oder zweiwertige aliphatische Gruppen unterbrochene aromatische Gruppe bedeuten und X ein Chlor- oder Bromatom darstellt, in einem inerten Lösungsmittel in Anwesenheit eines Lewis-Säure-Katalysators erhitzt. Die nach Verfahren (a) hergestellten Polysulfone enthalten die wiederkehrende Einheit

$$-A_1-SO_2-,$$

wohingegen die nach Verfahren (b) hergestellten Polysulfone die wiederkehrende Einheit

$$-A_1-SO_2-A_2-SO_2-$$

aufweisen.

Man kann auch Polyhydroxypolyetherpolysulfone einsetzen, welche man in an sich bekannter Weise, z.B. entweder (a) durch Reaktion eines zweiwertigen, von Sulfongruppen freien Phenols der Formel $HOA_3OH$ mit einem Diglycidylether eines zweiwertigen Phenols mit zwei durch eine Sulfongruppe verknüpfte Arylgruppen, welches die Formel

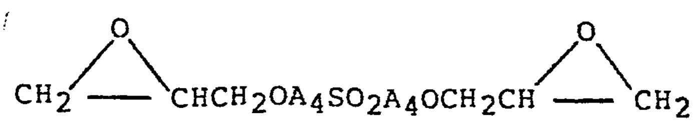

aufweist, und worin $A_3$ und $A_4$ zweiwertige Aryl-, insbesondere

gegebenenfalls durch Chlor oder niedere Alkylgruppen, z.B. Methylgruppen substituierte Phenylengruppen bedeuten; solcherart erhältliche Polysulfone weisen die wiederkehrende Einheit der Formel

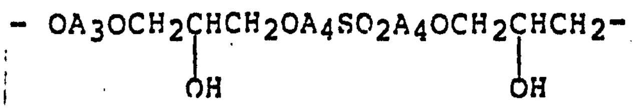

auf -

oder (b) durch Reaktion eines Dihydroxydiarylsulfons der Formel $HOA_3SO_2A_3OH$ mit einem Diglycidylether eines von Sulfongruppen freien Phenols der Formel

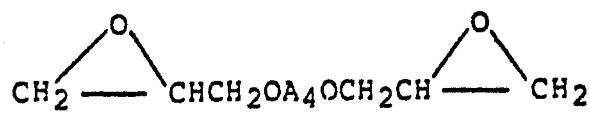

worin $A_3$ und $A_4$ den vorstehend zugewiesenen Bedeutungen entsprechen, und wobei die Polysulfone die wiederkehrende Einheit der Formel

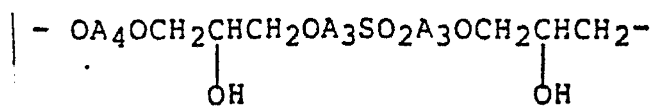

aufweisen,

oder (c) durch Reaktion eines Dihydroxydiarylsulfons der Formel $HOA_3SO_2A_3OH$ mit einem Diglycidylether eines zweiwertigen, zwei durch eine Sulfongruppe verknüpfte Arylgruppen aufweisenden Phenols der Formel

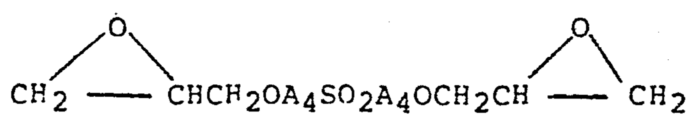

worin $A_3$ und $A_4$ den vorstehend zugewiesenen Bedeutungen entsprechen, wobei die Polysulfone die wiederkehrende Einheit der Formel

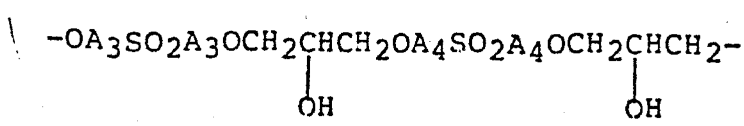

aufweisen, erhält.

In den erfindungsgemässen Massen bevorzugt verwendete Polysulfonharze sind solche, welche einen Gehalt an Ethergruppen in der wiederkehrenden Einheit aufweisen, jedoch von seitenständigen Hydroxylgruppen frei sind. Es handelt sich dabei besonders um Polysulfone mit einer wiederkehrenden Einheit der Formel

$$-OA_3OA_4SO_2A_4-$$

worin $A_3$ und $A_4$ die vorstehend zugewiesenen Bedeutungen besitzen. Man erhält derartige Polysulfone in an sich bekannter Weise durch Reaktion eines Dialkalimetallsalzes eines zweiwertigen Phenols der Formel $HOA_3OH$ mit einem Bis-(monochloraryl)-sulfon der Formel $ClA_4SO_2A_4Cl$ in Dimethylsulfoxid. Bevorzugtere Polysulfonharze sind solche mit einem Gehalt an einer wiederkehrenden Einheit der Formel

$$-OA_5-Y-A_5OA_6-SO_2-A_6-$$

worin $A_5$ und $A_6$ jeweils eine gegebenenfalls durch Chlor oder niedere Alkylgruppen wie z.B. Methylgruppen substituierte Phenylengruppe und Y eine Kohlenstoff-Kohlenstoffbindung, die $-SO_2-$ oder eine aliphatische Kohlenwasserstoffgruppe, insbesondere eine solche mit nicht mehr als vier Kohlenstoffatomen wie z.B. solche der Formel

$-CH_2-$ oder 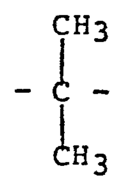

bedeuten.

Besonders bevorzugt sind thermoplastische Polysulfonharze mit einem Gehalt an einer wiederkehrenden Einheit der Formel

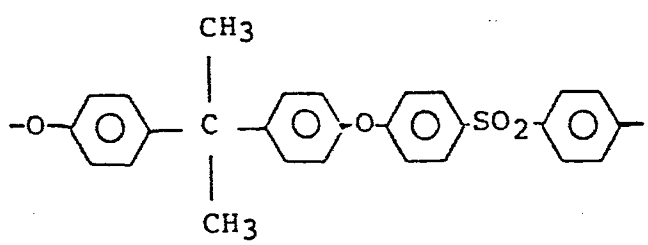 .

Die bevorzugtesten unter ihnen enthalten im Durchschnitt pro Molekül 50-120 solcher Einheiten.

Besonders vorteilhafte erfindungsgemässe Beispiele von Polysulfonen sind die folgenden:

"Polysulfon A" bezeichnet eine Substanz, die bei Union Carbide Corporation unter dem Namen "Polysulfone P1700" erhältlich ist; nach Angabe des Herstellers hat diese einen Schmelzpunkt im Bereich von 350-370°C, eine Wärmeformbeständigkeit (ASTM-Spezifikation D648) von 175°C und enthält im Durchschnitt pro Molekül 50-80 wiederkehrende Einheiten der Formel

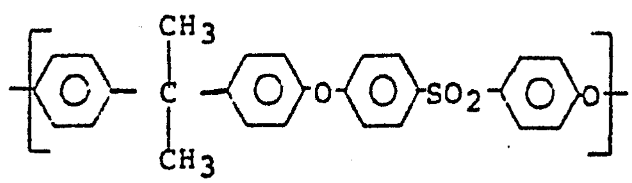

wobei man von einem Molekulargewichtsbereich von ungefähr 22 000-35 000 ausgehen kann.

"Polysulfon B" bezeichnet eine bei Union Carbide Corporation unter dem Namen "Polysulfone P2300" erhältliche ähnliche Substanz; nach Angaben des Herstellers hat diese einen Molekulargewichtsbereich von 30 000-50 000, wobei man davon ausgehen kann, dass die Substanz im Durchschnitt pro Molekül ungefähr 68-113 wiederkehrende Einheiten derselben Formel wie in "Polysulfon A" enthält.

"Polysulfon C" bezeichnet eine bei Union Carbide Corporation unter dem Namen "Polysulfone P3500" erhältliche ähnliche Substanz; nach Angaben des Herstellers hat diese einen Molekulargewichtsbereich, der zwischen dem von "Polysulfon A" und jenem von "Polysulfon B" liegt; das Molekulargewicht beträgt ca. 35 000.

Erfindungsgemäss verwendete Härter sind die Phenol- oder Kresol-Novolake mit wenigstens drei phenolischen Hydroxylgruppen pro Molekül.

Derartige Novolake werden zweckmässig durch Reaktion von Phenol, o-, m- oder p-Kresol mit einem niederen Alkanal, vorzugsweise Formaldehyd, zur Bildung eines im allgemeinen im Durchschnitt pro Molekül 3-10 phenolische Hydroxylgruppen enthaltenden Novolaks hergestellt.

Ein Beispiel für einen solchen Novolak ist o-Kresol-Novolak

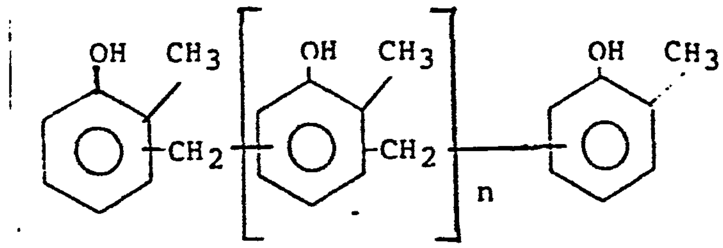

worin n 1-8 beträgt.

Weitere Beispiele für erfindungsgemäss vorteilhafte Novolak-Härter sind o-Kresolformaldehyd- oder Phenolformaldehyd-Novolak. Spezielle Novolak-Härter sind der o-Kresolformaldehyd-Novolak mit 1 OH/126 Gramm (Novolak-Härter 1) oder ein Phenolformaldehyd-Novolak mit 1 OH/107 Gramm (Novolak-Härter 2). Besonders bevorzugt ist der Novolak-Härter 1.

Der Anteil des in den vorliegenden Massen verwendeten Novolak-Härters wird im wesentlichen so bemessen, dass 0,85-1 phenolische Hydroxylgruppe pro Epoxigruppe der Epoxiharzkomponente der Masse entfallen.

Erfindungsgemäss vorteilhaft zu verwendende Beschleuniger sind tertiäre Amine, Anhydride, Harnstoffe, Dicyandiamide und Imidazole. Bevorzugte Beschleuniger sind die Imidazole wie z.B. das Imidazol selbst, 2-Methylimidazol und 2-Phenylimidazol. Es können auch tertiäre Amine wie z.B. Tri-(dimethylamino-methyl)-phenol, Dimethylaminomethylphenol oder Benzyldimethylamin eingesetzt werden.

Die vorliegenden Formmassen können auch herkömmliche Zusätze wie Egalisiermittel, Kuppler, thixotrope Mittel, Füllstoffe, Pigmente und eingearbeitete Formtrennmittel in geeigneten Mengen enthalten.

Die vorliegende Erfindung erstreckt sich auf besondere Gemische von Epoxiharzen und Polysulfonen mit speziellen Eigenschaften, welche sich ganz allgemein nicht durch einfaches Vermischen dieser beiden Polymeren oder durch ihr beliebiges Verhältnis zueinander erhalten lassen.

Tatsächlich müssen sich nicht nur die Verhältnis-

anteile von Polysulfon und Epoxiharz in einem relativ engen Bereich der Zusammensetzung bewegen, sondern auch die tatsächliche physikalische Form der beiden einander entsprechenden Polymere muss zusammenpassen.

Zur Erzielung der gewünschten Eigenschaften hinsichtlich überlegener Widerstandsfähigkeit gegenüber Rissbildung, Feuchtigkeit und thermischen Schock muss eine begrenzte Menge von 6-14 Gew.-% von Polysulfon, bezogen auf das Gesamtgemisch, innig im ganzen Epoxiharz dispergiert werden. Das blosse Vermahlen miteinander oder grossmassstäbliche Vermischen der beiden Polymere, selbst in diesem Bereich der Zusammensetzung, reicht nicht zur Verleihung der überlegenen Eigenschaften der gehärteten Masse aus.

Bei geringeren Gewichtsanteilen des Polysulfons im Epoxiharz als 6% lösen sich sowohl das Polysulfon als auch das Epoxiharz in den niedrig siedenden erfindungsgemäss verwendeten Lösungsmitteln im wesentlichen klar auf. Aus solchen Gemischen hergestellte härtbare Massen zeigen nicht die erhöhte Beständigkeit gegenüber Rissbildung, Feuchtigkeit und thermischem Schock.

Bei 6 gew.-%iger, insbesondere 8-12 gew.-%iger und ganz besonders bei 10-12 gew.-%iger Polysulfonkonzentration werden die in niedrig siedendem Lösungsmittel gebildeten Polysulfon/Epoxiharzlösungen trüb und zwar in demselben Mass stärker als die Polysulfonkonzentration selbst zunimmt. Die trüben Lösungen sind sehr gleichmässig; sobald das niedrig siedende Lösungsmittel anschliessend daraus entfernt wird, findet keine Agglomeration der einzelnen Polymerkomponenten statt, dafür aber eine allmähliche Einengung zu einem festen Gemisch aus Epoxiharz mit einer innigen Verteilung des Polysulfons darin. Aus solchen Gemischen hergestellte Formmassen härten zu Produkten mit überlegener Beständigkeit gegenüber Rissbildung, Feuchtigkeit und thermischem Schock aus.

Bei Polysulfonkonzentrationen von mehr als 14 Gew.-% werden die Lösungen des Polysulfons und Epoxiharzes in den

niedrig siedenden Lösungsmitteln zu viskos, um sie noch handhaben zu können. Derartige Lösungen sind nicht für eine ausreichende Dispergierung des Polysulfons im Epoxiharz geeignet.

Die vorliegenden Formmassen besitzen vier Komponenten, d.h. ein festes Epoxiharz, ein Polysulfon, einen Novolak-Härter und einen Beschleuniger. Das blosse Vermischen dieser Komponenten miteinander führt nicht zu Formmassen, welche gehärtete Harzprodukte mit überlegenen Eigenschaften ergeben.

Von wesentlicher Bedeutung ist es, zur Bildung des Gemisches (a) das Polysulfon zuerst in das Epoxiharz innig einzumischen, um die überlegenen Eigenschaften in den aus den vorliegenden Formmassen hergestellten gehärteten Harzprodukten zu erzielen.

Dies wird am zweckmässigsten so ausgeführt, dass man zuerst das feste Epoxiharz (1) und das Polysulfon (2) in einem niedrig siedenden Lösungsmittel zur Erzielung einer homogenen Lösung auflöst. Damit erreicht man ein inniges Vermischen von Epoxiharz und Polysulfon in Lösung auf im wesentlichen molekularer Ebene.

Man entfernt dann das niedrig siedende Lösungsmittel durch Destillation, wobei die letzten Spuren zur Gewinnung des Gemisches (a) bei vermindertem Druck entfernt werden. Das Gemisch (a) stellt bei Kühlung auf Raumtemperatur einen trüben Feststoff dar, worin das Polysulfon innig in das Epoxiharz eingemischt ist.

Zur Herstellung des Gemisches (a) ist eine Reihe von niedrig siedenden Lösungsmitteln verwendbar. Die Auswahlkriterien dabei sind wie folgt:

- Ein Siedepunkt zwischen 50 und 110°C,
- die Fähigkeit, sowohl das Epoxiharz als auch das Polysulfon zu lösen und
- die Fähigkeit in im wesentlichen gleichen Ausmass zur Lösung sowohl des Epoxiharzes als auch des Polysulfons, um jegliche unerwünschte Ansammlung von Lösungsmittel in einem Polymer zu vermeiden, was eine Aggregation besagten

Polymers nach Entfernung des Lösungsmittels verursachen und die innige Dispergierung des Polysulfons im Epoxiharz verhindern könnte.

Die zur Herstellung des Gemisches (a) vorteilhaften Lösungsmittel sind niedrig siedende Ether wie z.B. Tetrahydrofuran, Diisopropylether oder Dioxan sowie niedrig siedende Ketone wie z.B. Aceton oder Methylethylketon.

Bevorzugt ist Tetrahydrofuran als Lösungsmittel.

Die erfindungsgemässen Formmassen führen zu gehärteten Produkten mit signifikant verbesserter thermischer Schockrissfestigkeit für die Einbettung von Halbleitern ohne Verringerung anderer wünschenswerter Formmasseneigenschaften.

Die Viskosität der Formmassen kann durch geschickte Auswahl des Epoxiharzes und Polysulfons eingestellt und die Verformbarkeitscharakteristika der besagten Stoffe können durch das geeignete Auswählen der eingesetzten Mengen und Typen von Beschleunigern und Füllstoffen variiert werden.

Die mit den vorliegenden Formmassen erhältlichen wünschenswerten Eigenschaften sind die folgenden:

(a) Feuchtigkeitsabsorption

Die Beständigkeit des Einbettungsmaterials gegenüber Feuchtigkeit ist ein wichtiger Faktor für die Zuverlässigkeit der Bauelemente. Es konnte gezeigt werden, dass, sobald Wasser in das Gehäuse eindringt, bestimmte Arten von Stoffen einschliesslich Natrium-, Kalium- und Chloridionen mobilisiert werden, so dass durch sie eine Korrosion metallisierter Stellen in den Bauelementen eintritt, die zu Ausfällen führt.

Die vorliegenden gehärteten Formmassen zeigen eine signifikant niedrigere Feuchtigkeitsabsorption als gehärtete Formmassen ohne einen Gehalt an Polysulfon.

(b) Schlagfestigkeit

Im Vergleich zu vielen anderen Formulierungen auf Epoxiharzbasis geht man davon aus, dass dem Epoxi B-System Sprödigkeit bei gleichzeitig geringer Schlagfestigkeit zu eigen ist. Anlässlich der vorliegenden Modifizierung, welche in erster Linie die thermische Spannungsrissbildung

verbessern soll, wurde gefunden, dass auch die Schlagfestigkeit verbessert wird.

(c) Glasübergangstemperatur

Wenn man Epoxiharz zwecks Verbesserung der Härtungseigenschaften wie z.B. Schlagfestigkeit, Zähigkeit und Rissbeständigkeit modifiziert, verringert man nicht selten die Glasübergangstemperatur der gehärteten Masse. Die vorliegenden Formmassen zeigen nach der Härtung eher eine Erhöhung der Glasübergangstemperatur um 8-11% als eine Erniedrigung.

(d) Rissbeständigkeit bei thermischem Schock

Das vorrangige Ziel bei der Entwicklung der vorliegenden Formmassen ist die Verbesserung der Rissbeständigkeit bei thermischem Schock von kunststoffeingebetteten Halbleitern, welche im Format von DIP-Gehäusen (dual-in-line / DIL) hergestellt werden.

Erfahrungsgemäss sind an Probestücken gewonnene Daten über Rissbildung völlig verschieden von jenen von Bauelementen, die beim praktischen Einsatz zu beobachten sind, so dass Versuchswerte wegen geometrisch bedingter Spannungseffekte selten unmittelbar auf die Praxis übertragbar sind.

Zur möglichst weitgehenden Vermeidung dieser geometrisch bedingten Einflüsse wurde ein Test auf DIP-Formatbasis entwickelt.

Zunächst wurde ein mit einem 16-Leiter-Kupferrähmchen verbundenes Siliciumchip-Testmuster vorbereitet. Man fand jedoch heraus, dass dieser Bauteil sehr schwer zum Reissen durch weit mehr als 500 3-Minuten thermische Zyklen von -200°C bis +170°C gebracht werden konnte, bis ein Ausfall bemerkbar wurde. Zur Verringerung der zum Ausfall führenden Anzahl von Zyklen bis auf eine praktikable Anzahl wurde der Siliciumchip-Testbauteil gegen eine Edelstahlunterlegscheibe ausgewechselt. Dieser Austausch resultierte in grösserer Spannungsbildung innerhalb des Gehäuses, wobei ein Ausfall bereits nach 15 Zyklen herbeigeführt wurde.

Das Testmuster stellt man her, indem man die

Edelstahlunterlegscheibe mit dem schaufelförmigen Teil des Kupferleitungsrähmchens unter Verwendung eines nichtleitenden füllstofffreien Epoxiharzklebers verbindet. Danach wird das Leiterrähmchen mittels Spritzpressen eingebettet. Die Einbettung wurde mittels einer 20-Loch-Handpressform und eine Hull-12-Tonnen-Spritzpresse vorgenommen. Jede Rezeptur wurde unter denselben Bedingungen geformt und nachgehärtet, um durch den Formprozess bedingte Spannungsunterschiede zu eliminieren.

Die DIP-Gehäuse werden daraufhin herausgetrennt und durch 1,5-minütiges Eintauchen in flüssigen Stickstoff bei -200$^{o}$C und unmittelbar danach durch 1,5-minütiges Einbringen in +170$^{o}$C heisses Silikonöl einem thermischen Schock ausgesetzt. Das zweimalige Eintauchen von jeweils 1,5 Minuten bedeutet einen 3-Minuten-Zyklus. Nach jeweils 15 Zyklen prüft man die Muster visuell bei 10-facher Vergrösserung auf über die Breite sich ausdehnende Risse, welche den Ausfall anzeigen.

Die auf den vorliegenden Formmassen basierenden Rezepturen halten signifikant mehr Zyklen stand als die nichtmodifizierte Epoxi/Kresol-Novolak (ECN)-Harzformulierung, bevor 60-70% der Bauteile gerissen sind. Tatsächlich ist noch keines der mit modifiziertem ECN hergestellten DIP-Gehäuse gerissen, wenn nach 90 Zyklen alle der mit nichtmodifiziertem ECN produzierten DIP-Gehäuse zersprungen sind. Dies demonstriert die ausgeprägte Ueberlegenheit der modifizierten ECN-Harze gegenüber dem Standard-ECN-Harz.

Die folgenden Beispiele sind lediglich zur Erläuterung gedacht und sollen nicht als beschränkende Auslegung nach Art oder Umfang der vorliegenden Erfindung, in welcher Weise auch immer, verstanden werden. Die jeweils angegebenen Teile bedeuten Gewichtsteile.

## Beispiel 1

### Herstellung des Harzgemisches

Ein erfindungsgemäss verwendbares Harzgemisch wird in typischer Weise durch Zugabe von 12 Teilen gepulverten Polysulfons unter Rühren in ein geschlossenes, mit

einem Rührer und Rückflusskühler ausgestattetes Gefäss, welches 80 Teile Tetrahydrofuran enthält, hergestellt. Man erwärmt das Tetrahydrofuran bis zum Rückfluss, und das Polysulfon löst sich darin auf. Anschliessend fügt man zu dieser unter Rückfluss kochenden Lösung 88 Teile Epoxiharzgranulat hinzu und kocht so lange unter Rückfluss weiter, bis sich auch das Epoxiharz aufgelöst hat. Die so erhaltene Lösung des Polysulfons und Epoxiharzes in Tetrahydrofuran ist leicht trüb.

Schliesslich entfernt man das Tetrahydrofuran-Lösungsmittel mittels Destillieren, wobei man die Gefässtemperatur bei 160-165°C hält und beseitigt restliche Spuren von Tetrahydrofuran unter einem verringerten Druck von 6,7-13,3 kPa (50-100 mm Hg), wobei unter anhaltendem Rühren des Polymergemisches eine Temperatur von 165°C herrschen soll. Die heisse, einheitliche, trübe Polymermischung entleert man in einen Tiegel, wo sie zu einer aus Epoxiharz mit innig darin dispergiertem Polysulfon bestehenden festen Masse aushärtet.

## Beispiel 2

## Herstellung der Formmasse

Eine erfindungsgemässe Formmasse wird typischerweise mittels des Zwei-Komponenten-Heisswalzenmahlverfahrens hergestellt. Bei diesem Verfahren beschickt man die Heisswalzenmühle mit dem nach Beispiel 1 hergestellten Harzgemisch zusammen mit etwas Füllstoff, wobei jedoch der Novolak-Härter, der restliche Füllstoff und Beschleuniger separat eingearbeitet werden. Nach der Bearbeitung in der Heisswalzenmühle werden die beiden Komponenten homogen im richtigen Verhältnis zusammengemischt und bei Raumtemperatur granuliert, wobei sie die Formmasse oder Zusammensetzung ergeben.

## Beispiel 3

## Herstellung eines gehärteten Musters

Man stellt zwecks Beurteilung der Eigenschaften der aus den gemäss Beispiel 2 herstellbaren Formmassen erhältlichen gehärteten Produkte ein Testmuster her. Dies

geschieht mittels Spritzpressen bei 150-165°C Formtemperatur und 4,12-6,87 MPa (42-70 kg/cm$^2$) Kolbenpressdruck von 3 Minuten Dauer. Das Nachhärten geschieht bei 175°C und 4 Stunden Dauer für alle Testmuster.

## Beispiel 4

Formmassen einer Zusammensetzung gemäss nachstehender Tabelle werden nach dem in Beispiel 2 beschriebenen Verfahren hergestellt und nach dem in Beispiel 3 angegebenen Verfahren gehärtet. Sie werden auf Feuchtigkeitsbeständigkeit, Schlagfestigkeit, Rissbeständigkeit bei thermischem Schock und Glasübergangstemperatur wie nachstehend erläutert getestet.

| Komponenten [a] | Rezeptur (Gewichtsteile) | | | | | |
|---|---|---|---|---|---|---|
| | A | B | C | D | E | F |
| Harz 1 | 100 | | | | | |
| Harz 1 mit 12% P1700 | | 100 | | | | |
| Harz 1 mit 12% P3500 | | | 100 | | | |
| Harz 2 | | | | 100 | | |
| Harz 2 mit 12% P1700 | | | | | 100 | |
| Harz 2 mit 12% P3500 | | | | | | 100 |
| Novolak-Härter 1 | 47 | 47 | 47 | 42 | 42 | 42 |
| Imidazol | 1 | 1 | 1 | 1 | 1 | 1 |
| Trennmittel | 1 | 1 | 1 | 1 | 1 | 1 |
| Füllstoff | 277 | 277 | 277 | 267 | 267 | 267 |

a. Komponenten sind wie folgt:

Harz 1: Epoxi/o-Kresol/Formaldehyd-Novolak mit einem Schmelzpunkt von 73°C, einem Molekulargewicht von ca. 1080 und einem Epoxiwert von 0,445 Aequiv./100 Gramm.

Harz 2: Epoxi/o-Kresol/Formaldehyd-Novolak mit einem Schmelzpunkt von 80°C, einem Molekulargewicht von ca. 1170 und einem Epoxiwert von 0,435 Aequiv./100 Gramm.

P1700: Polysulfonharz (Union Carbide) mit einem Molekulargewicht von ca. 22 000.

P 3500: Polysulfonharz (Union Carbide) mit einem Molekulargewicht von ca. 35 000.

Novolak-Härter 1: o-Kresol/Formaldehyd-Novolak mit einem Hydroxylwert von 1 OH/126 Gramm.

Trennmittel: Montanwachs.

Füllstoff: 325 Novacite (gepulverter Quarz mit einer Siebmaschenweite von 325).

a. Feuchtigkeitsbeständigkeit

Man stellt Scheiben von einer Grösse von 10,16 cm x 0.32 cm durch Spritzpressen mittels des Verfahrens nach Beispiel 3 her und verbringt sie in einen Autoklav mit einem Druck von 103 kPa (1,05 $kg/cm^2$) und einer Temperatur von 121°C. Dort verbleiben sie 24 Stunden lang. Man bestimmt die Gewichtszunahme, welche in Prozent in Bezug auf das ursprüngliche Trockengewicht angegeben ist.

| Gehärtetes Muster der Rezeptur | Gewichtszunahme in % | Verbesserung gegenüber Kontrolle in % |
|---|---|---|
| A | 0,78 | - |
| B | 0,57 | 27 |
| C | 0,63 | 19 |
| D | 0,78 | - |
| E | 0,51 | 35 |
| F | 0,61 | 22 |

Diese Daten zeigen an, dass die aus den erfindungsgemässen Formmassen hergestellten Scheiben eine überlegene Feuchtigkeitsbeständigkeit im Vergleich zu den aus Formmassen ohne Polysulfonzusatz hergestellten Scheiben aufweisen.

b. Schlagfestigkeit

Man stellt nach dem Verfahren gemäss Beispiel 3 Scheiben in der Grösse 5,08 cm x 0,32 cm her. Die Scheiben werden dann mittels eines Gardner Schlagtestgeräts nach dem üblichen Messverfahren gemäss ASTM D-3029 einem Fallgewichtsaufschlag unterzogen.

| Gehärtetes Muster der Rezeptur | Für den Bruch notwendige Aufschlagstärke Inch-Pfund (kg.m) | Verbesserung gegenüber Kontrolle in % |
|---|---|---|
| A | 3,00 (0,033) | - |
| B | 4,00 (0,044) | 33 |
| C | 3,75 (0,041) | 25 |
| D | 3,00 (0,033) | - |
| E | 4,00 (0,044) | 33 |
| F | 3,75 (0,041) | 25 |

Wiederum zeigen die mit Hilfe der erfindungsgemässen Formmassen hergestellten Scheiben eine verbesserte Schlagfestigkeit gegenüber der ohne Verwendung von Polysulfon hergestellten Kontrolle.

c. Thermische Schockbeständigkeit

Ein 16-Leiter-Kupferrähmchen wird in der Weise umgebaut, dass man daran unter Verwendung eines 5-Minuten-Epoxiklebers eine Edelstahlunterlegscheibe mit einem Innendurchmesser von 2,26 mm, einem Aussendurchmesser von 4,76 mm und einer Dicke von 0,71 mm anheftet. Danach bettet man die an der Unterlegscheibe befindlichen Zuleitungen mittels Spritzpressen, wie beim Verfahren nach Beispiel 3 angegeben, so ein, dass ein 16-Leiter-DIP-Gehäuse in Standardmassen entsteht.

Man setzt zehn Muster der einzelnen Rezepturen jeweils 1,5 Minuten lang zuerst bei 170°C in einem Silikonölbad und dann durch Eintauchen bei -200°C in flüssigen Stickstoff einem thermischen Schock aus.

Man führt die visuelle Prüfung der Muster nach jeweils 15 Zyklen in der Weise durch, dass man einen Ausfall dann wertet, wenn bei 10-facher Vergrösserung ein über die

Breite des DIP-Gehäuses sich erstreckender Riss sichtbar wird.

Die Vergleichsversuchswerte werden in der nachstehenden Tabelle gezeigt.

Ausfälle/Zyklen (Ausfälle pro zehn Muster)

| Gehärtetes Muster der Rezeptur | 15 | 30 | 45 | 60 | 75 | 90 | 105 | 120 | 135 | 150 | 165 | 180 | 195 | 210 | 225 | 240 | 255 | 270 | 285 | 300 |
|---|---|---|---|---|---|---|---|---|---|---|---|---|---|---|---|---|---|---|---|---|
| A | 3 | 6 | 8 | 9 | 9 | 10 | | | | | | | | | | | | | | 10 |
| B | 0 | | 1 | | | 2 | 4 | 5 | 6 | 7 | 8 | | | 9 | | | | | | 9 |
| C | 0 | | | | | | | | | | | 2 | 3 | | | | 4 | 6 | 7 | 7 |
| D | 3 | 6 | 8 | 9 | 9 | 10 | | | | | | | | | | | | | | 10 |
| E | 0 | | | | | | | 1 | | | | | | | | | 2 | | | 2 |
| F | 0 | | | | | | 1 | | 2 | | | | 3 | 4 | 5 | | | | 6 | 7 |

Aus der vorstehenden Tabelle ist ersichtlich, dass sämtliche mittels Polysulfon modifizierten Systeme der Kontrolle weit überlegen sind. Das schwächste der modifizierten Systeme erreicht erst bei 150 Zyklen eine 80%ige Ausfallsrate, wogegen die Kontrolle schon nach 45 Zyklen eine 80%ige Ausfallsrate erreicht. Die restlichen drei Systeme erreichen selbst nach 300 Zyklen noch keine 80%ige Ausfallsrate.

d. Glasübergangstemperatur

Die Glasübergangstemperaturen der nach dem Verfahren gemäss Beispiel 3 hergestellten, gehärteten Muster werden unter Benutzung eines Perkin-Elmer thermomechanischen Analysators unter Zugrundelegung der thermomechanischen Analyse des Ausdehnungsverhaltens ermittelt.

Die so erhaltenen Messwerte sind untenstehend angegeben.

| Gehärtetes Muster der Rezeptur | Glasübergangstemperatur °C |
|---|---|
| A | 165-170 |
| B | 179 |
| C | 180 |
| D | 165-170 |
| E | 179-182 |
| F | 185 |

Sämtliche aus den erfindungsgemässen Formmassen hergestellte gehärtete Muster ergeben um etwa 9-15°C höhere Glasübergangstempraturen als die aus Formmassen ohne Verwendung von Polysulfon hergestellten Muster.

## Beispiel 5

Die in Beispiel 4 beschriebenen Formmassen enthalten jeweils eine Epoxi/Kresol-Novolak-Komponente. Dieses Beispiel beschreibt Formmassen, worin das feste Epoxiharz auf Bisphenol A basiert oder ein Epoxi/Phenol-Novolak(EPN)-Harz ist. Dies zeigt, dass die vorliegende Erfindung nicht auf die Verwendung von Epoxi/Kresol-Novolaken als Epoxiharz beschränkt ist.

Die folgenden Formmassen wurden unter Anwendung des Verfahrens nach Beispiel 4 hergestellt und auf

thermische Schockrissbeständigkeit getestet.

| Komponenten [a] | Rezeptur (Gewichtsteile) | | | |
|---|---|---|---|---|
| | G | H | I | J |
| Harz 5 | 100 | | | |
| Harz 5 mit 12% P1700 | | 100 | | |
| Harz 4 | | | 100 | |
| Harz 4 mit 12% P1700 | | | | 100 |
| Novolak-Härter 1 | 55,7 | 49,3 | 21,4 | 19,3 |
| Imidazol | 1 | 1 | 1 | 1 |
| Trennmittel | 1 | 1 | 1 | 1 |
| Füllstoff | 293 | 281 | 292 | 225 |

a. Die Komponenten sind wie folgt:

Harz 5: Ein fester Epoxi/Phenol-Novolak mit einem Molekulargewichtsbereich von 4000-5600.

Harz 4: Auf Bisphenol A basierendes vorverlängertes Epoxiharz mit einem Molekulargewicht von 2000.

P1700: Polysulfonharz (Union Carbide) mit einem Molekulargewicht von ca. 22 000.

P3500: Polysulfonharz (Union Carbide) mit einem Molekulargewicht von ca. 35 000.

Novolak-Härter 1: o-Kresol/Formaldehyd-Novolak mit einem Hydroxylwert von 1 OH/126 Gramm.

Trennmittel: Montanwachs.

Füllstoff: 325 Novacite (pulverisierter Quarz mit einen Siebmaschenweite von 325).

Die Messwerte für die Rissbeständigkeit bei thermischem Schock, welche bei den gehärteten Mustern der Rezepturen G, H, I und J erhalten wurden, sind in der folgenden Tabelle angegeben.

Ausfälle/Zyklen (Ausfälle pro zehn Muster)

| Gehärtetes Muster der Rezeptur | 15 | 30 | 45 | 60 | 75 | 90 | 105 | 120 | 135 | 150 | 165 | 180 | 195 | 210 |
|---|---|---|---|---|---|---|---|---|---|---|---|---|---|---|
| G | 4 | 8 | 9 | 10 | | | | | | | | | | |
| H | | 3 | 6 | 9 | 10 | | | | | | | | | |
| I | | 1 | 2 | 3 | 5 | 6 | 10 | | | | | | | |
| J | | | | 1 | | 2 | | 4 | | 5 | 6 | 8 | | |

Man kann im Falle der Rezeptur G auf Basis des festen EPN-Harzes erkennen, dass der Zusatz von 12 Gew.-% Polysulfon (Rezeptur H) lediglich eine mässige Verbesserung in der Rissbeständigkeit ergibt.

Eine mögliche Erklärung dafür mag darin zu sehen sein, dass das feste EPN-Harz in Tetrahydrofuran weniger löslich ist als die festen ECN-Harze gemäss Beispiel 4. Diese Löslichkeitsunterschiede können offenbar die Art und Weise der Dispergierung des Polysulfons im EPN nach dem Verfahren gemäss Beispiel 1 beeinflussen.

Es ist zu erwarten, dass die Wahl eines unterschiedlichen und optimalen niedrig siedenden Lösungsmittels für die Herstellung des EPN/Polysulfonharz-Gemischs zu gehärteten Formmassen auf Basis EPN mit deutlich verbesserter thermischer Schockbeständigkeit führt.

Die Ueberprüfung der gehärteten Muster gemäss Rezepturen I und J zeigt, dass die Rezeptur J eine bemerkenswerte Verbesserung der thermischen Schockbeständigkeit bei den erfindungsgemässen Formmassen auf Basis einer festen Bisphenol A/Epoxiharz/Polysulfon-Mischung aufweist.

## Beispiel 6

Zur Ermittlung des Effekts der Menge an Polysulfon stellt man erfindungsgemässe Formmassen auf Basis Epoxi/Kresol-Novolak (ECN) mit Polysulfon her, wie in Beispiel 4 beschrieben ist, jedoch mit 8, 10 oder 12 Gew.-% Polysulfon. Das Verhalten der thermischen Schockbeständigkeit der gehärteten Formmassenmuster wird, wie in Beispiel 4 beschrieben, gemessen. Die Rezepturen sind nachstehend aufgelistet und enthalten auch die anderen für die Rezepturen A und B gemäss Beispiel 4 aufgelisteten Bestandteile.

| Rezeptur | Harzgemisch [a] |
|---|---|
| A | Harz 1 |
| B | Harz 1 mit 12% P1700 |
| K | Harz 1 mit 10% P1700 |
| L | Harz 1 mit 8% P1700 |

a. Harz 1: Epoxi/o-Kresol/Formaldehyd-Novolak mit einem

Schmelzpunkt von 73°C, einem Molekulargewicht von ca. 1080 und einem Epoxiwert von 0,445 Aequiv./100 Gramm.

P1700: Polysulfonharz (Union Carbide) mit einem Molekulargewicht von 22 000.

**Ausfälle/Zyklen (Ausfälle pro zehn Muster)**

| Gehärtetes Muster der Rezeptur | 15 | 30 | 45 | 60 | 75 | 90 | 105 | 120 | 135 | 150 | 165 | 180 | 195 | 210 | 225 | 240 | 255 | 270 | 285 | 300 |
|---|---|---|---|---|---|---|---|---|---|---|---|---|---|---|---|---|---|---|---|---|
| A | 3 | 6 | 8 | 9 | 9 | 10 | | | | | | | | | | | | | | 10 |
| A (Wiederholungstest) | 4 | 6 | 9 | 10 | | | | | | | | | | | | | | | | |
| B | 0 | | 1 | | | 2 | 4 | 5 | 6 | 7 | 8 | | | 9 | | | | | | 9 |
| K | 0 | | | | 1 | | 2 | | 3 | | | 4 | 5 | | | | | | | |
| L | | 3 | | | | 4 | 6 | 9 | 10 | | | | | | | | | | | |

Die Ueberprüfung der Messwerte zeigt, dass der Zunahme des Polysulfonanteils von 8 Gew.-% (Rezeptur L) auf 10 Gew.-% (Rezeptur K) bis auf 12 Gew.-% Polysulfon (Rezeptur B), auch die thermische Schockbeständigkeit steigt unter Erzielung optimaler Eigenschaften bei Formmassen mit einem Gehalt von 10 bis 12 Gew.-% Polysulfon im Harzgemisch nach Beispiel 1.

Patentansprüche

1. Härtbare Formmassen für gehärtete Harze mit überlegener Widerstandsfähigkeit gegen Rissbildung, Feuchtigkeit und thermischen Schock, dadurch gekennzeichnet, dass sie (a) ein Gemisch, bestehend aus (1) 94-86 Gew.-% eines festen Epoxiharzes mit einem Molekulargewicht von mindestens 750, bezogen auf Gemisch (a) und (2) 6-14 Gew.-% eines Polysulfons mit einem Molekulargewicht von mindestens 10 000, bezogen auf Gemisch (a), wobei das Polysulfon (2) im Epoxiharz (1) zwar unlöslich ist, aber darin in innig verteilter Form vorliegt, und wobei vorstehendes Gemisch (a) in der Weise gebildet wird, dass man das Epoxiharz (1) und das Polysulfon (2) zusammen in einem niedrig siedenden Lösungsmittel zur Erzielung einer homogenen Lösung auflöst und danach das Lösungsmittel zur Gewinnung des Gemisches (a) entfernt, (b) einen Novolak-Härter und (c) eine wirksame Menge eines Beschleunigers enthalten, wobei die Menge an Novolak-Härter (b) im wesentlichen so bemessen ist, dass 0,85-1 phenolische Hydroxylgruppe pro Epoxigruppe im Epoxiharz (1) entfallen.

2. Masse nach Anspruch 1, dadurch gekennzeichnet, dass das feste Epoxiharz ein festes Bisphenol A-Epoxiharz, ein Epoxi/Phenol-Novolak oder Epoxi/Kresol-Novolak ist.

3. Masse nach Anspruch 2, dadurch gekennzeichnet, dass das feste Epoxiharz ein Epoxi/Kresol-Novolak ist.

4. Masse nach Anspruch 1, dadurch gekennzeichnet, dass das für die Herstellung des Gemisches (a) verwendete niedrig siedende Lösungsmittel Tetrahydrofuran ist.

5. Masse nach Anspruch 1, dadurch gekennzeichnet, dass der Beschleuniger Imidazol ist.

6. Masse nach Anspruch 1, dadurch gekennzeichnet, dass das Gemisch (a) 8 bis 12 Gew.-% Polysulfon enthält.

7. Masse nach Anspruch 6, dadurch gekennzeichnet, dass das Gemisch (a) 10 bis 12 Gew.-% Polysulfon enthält.